# EUROPEAN PATENT APPLICATION

(11) **EP 2 684 647 A1**
(43) Date of publication of application: **15.01.2014**
(21) Application number: 11860507.0
(22) Date of filing: 21.12.2011
(51) Int. Cl.: B25F 5/00, G01R 31/36, H01M 2/10, H01M 10/48, H02J 7/02, H02J 7/04

(54) **ELECTRIC TOOL USING SECONDARY CELLS AS POWER SOURCE**

(30) Priority: 07.03.2011 JP 2011048892
(71) Applicant: Makita Corporation, Anjo-shi, Aichi 446-8502 (JP)
(72) Inventor: SUZUKI Hitoshi, Anjo-shi Aichi 446-8502 (JP); TAGA Hideyuki, Anjo-shi Aichi 446-8502 (JP); OGURA Hironori, Anjo-shi Aichi 446-8502 (JP); EGUCHI Kenta, Anjo-shi Aichi 446-8502 (JP); KIMURA Kazuya, Anjo-shi Aichi 446-8502 (JP)
(74) Representative: Kramer - Barske - Schmidtchen
(86) International application number: PCT/JP2011/079645
(87) International publication number: WO 2012/120750

(57) **Abstract**

An electric power tool is powered by a plurality of rechargeable battery cells and configured to removably receive respective rechargeable battery cells individually. The electric power tool may preferably include a monitor circuit that monitors states of respective battery cells, and an indicator circuit that indicates the states of the respective battery cells monitored by the monitor circuit. Especially, the monitor circuit may preferably monitor output voltages of the respective rechargeable battery cells and the indicator circuit may preferably indicate whether the detected output voltages are within a predetermined range.

## Description

### TECHNICAL FIELD

The present disclosure relates to an electric power tool powered by a plurality of rechargeable battery cells.

### BACKGROUND ART

JPH07-161340A (2005) discloses an electric power tool. The electric power tool includes a tool main body and a battery pack configured to be detachably attached to the tool main body. A plurality of rechargeable battery cells is housed in the battery pack and electric power is supplied from the plurality of rechargeable battery cells to the tool main body.

### SUMMARY OF INVENTION

### Technical Problem

Rechargeable battery cells deteriorate when the cells are repeatedly charged and discharged. Thus, when a battery pack is used repeatedly, the performance of the battery pack decreases, and as a result, the battery pack needs to be replaced. However, inspection of degraded battery packs found that not all of the rechargeable battery cells are deteriorated, but only part of the rechargeable battery cells is greatly deteriorated. Therefore, in a conventional electric power tool, when the degraded battery pack is replaced, rechargeable battery cells that are still usable are also discarded.

Accordingly, in the field of an electric power tool powered by a plurality of rechargeable battery cells, the present disclosure provides a technique for preventing rechargeable battery cells from being wastefully discarded.

### Solution to Technical Problem

In order to solve the problem, the present disclosure employs an electric power tool powered by a plurality of rechargeable battery cells and configured to removably receive respective rechargeable battery cells individually. With this configuration, it is possible to selectively replace only one rechargeable battery cell that is deteriorated or broken and therefore to prevent usable rechargeable battery cells being wastefully discarded.

### BRIEF DESCRIPTION OF DRAWINGS

FIG. 1 shows an appearance of a tool main body and a battery pack according to a first embodiment.
FIG. 2 shows a battery pack detached from a tool main body.
FIG. 3 shows a battery pack of which a cover of a housing is open.
FIG. 4 shows an appearance of a pack charger.
FIG. 5 shows an appearance of a cell charger.
FIG. 6 shows a circuit configuration of the tool main body and the battery pack according to the first embodiment, in which part of a plurality of rechargeable battery cells is not illustrated.
FIG. 7 shows a modification of a circuit configuration of a tool main body and a battery pack.
FIG. 8 shows another example of a battery pack.
FIG. 9 shows another example of a battery pack.
FIG. 10 shows an electric power tool according to a second embodiment.
FIG. 11 is a view along line XI-XI in FIG. 10.
FIG. 12 is a view along line XII-XII in FIG. 10.
FIG. 13 shows a circuit configuration of the electric power tool according to the second embodiment, in which part of a plurality of rechargeable battery cells is not illustrated.
FIG. 14 shows an appearance of an electric power tool according to a third embodiment.
FIG. 15 is a cross-sectional view along line XV-XV in FIG. 14.
FIG. 16 is a cross-sectional view along line XVI-XVI in FIG. 14.

### EMBODIMENTS OF THE INVENTION

In an embodiment of the present disclosure, the electric power tool may preferably further include: a monitor circuit configured to monitor states of respective battery cells; and an indicator circuit configured to indicate the states of the respective battery cells monitored by the monitor circuit. According to this configuration, a user can specify a rechargeable battery cell that is deteriorated or broken and properly replace the rechargeable battery cell.

In the embodiment, the monitor circuit may preferably be configured to monitor at least one of output voltages and temperatures of the respective battery cells. In this case, the indicator circuit may preferably be configured to indicate whether the output voltages or the temperatures of the respective battery cells are within a predetermined range. The predetermined range mentioned herein is a numerical range that is set in advance in an electric power tool, and for example, means a predetermined upper limit value or smaller, a predetermined lower limit value or larger, or a range of values equal to or smaller than a predetermined upper limit value and equal to or larger than a predetermined lower limit value.

In an embodiment of the present disclosure, the electric power tool may further include a switch circuit configured to shut off electric power supply from the plurality of rechargeable battery cells. In this case, the monitor circuit may preferably be configured to make the switch circuit open when the output voltage of at least one rechargeable battery cell is beyond the predetermined range. Due to this, it is possible to prevent the deteriorated or broken rechargeable battery cell from being used.

In an embodiment of the present disclosure, the electric power tool may include: a tool main body; and a battery pack configured to be detachably attached to the tool main body. The battery pack may be configured to house the plurality of rechargeable battery cells. The respective rechargeable battery cells may preferably be detachably attached to the battery pack individually. However, in another embodiment, the electric power tool may not include such a battery pack that is detachably attached, but a plurality of rechargeable battery cells may be directly received in the tool main body.

In the aforementioned embodiment, the electric power tool may preferably further include a pack charger that charges the battery pack. In this case, the battery pack may preferably include a monitor circuit configured to monitor states of the respective battery cells. Moreover, the pack charger may preferably be configured to be connected with the monitor circuit in a communicable fashion and include an indicator circuit configured to indicate states of the respective battery cells monitored by the monitor circuit.

In an embodiment of the present disclosure, the electric power tool may preferably further include a cell charger that charges the rechargeable battery cell detached from the electric power tool. In this case, the cell charger may preferably include a temperature sensor that detects a temperature of the rechargeable battery cell. According to this configuration, the cell charger can appropriately control the charging according to the temperature of the rechargeable battery cell.

The cell charger may preferably be configured to finish charging of the rechargeable battery cell when the output voltage of the rechargeable battery cell under the charging reaches a predetermined upper limit or when a predetermined period of time passes from a start of the charging. Due to this, it is possible to prevent overcharging of the rechargeable battery cell and to prevent a deteriorated or broken rechargeable battery cell from being wastefully charged continuously.

### FIRST EMBODIMENT

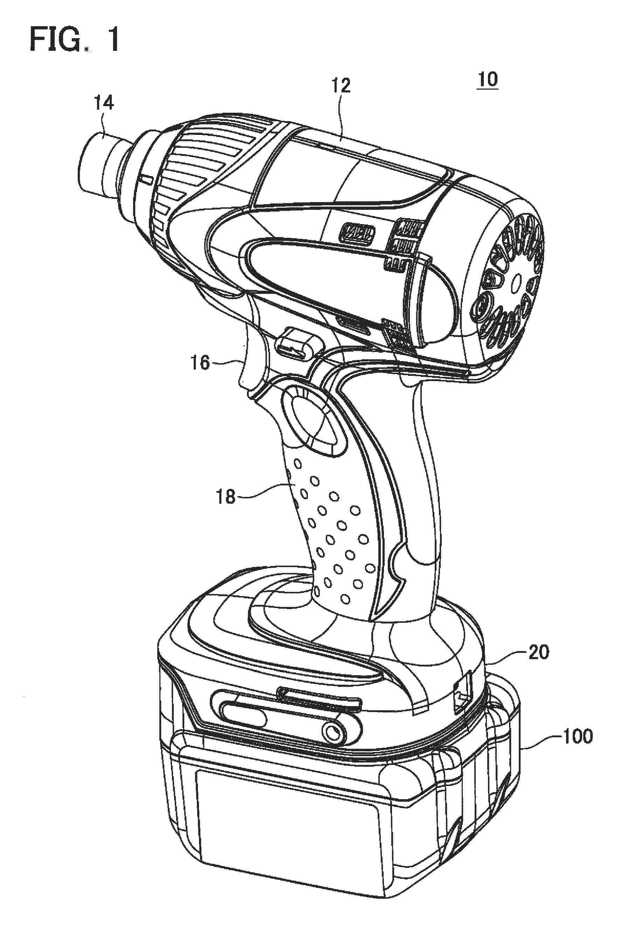

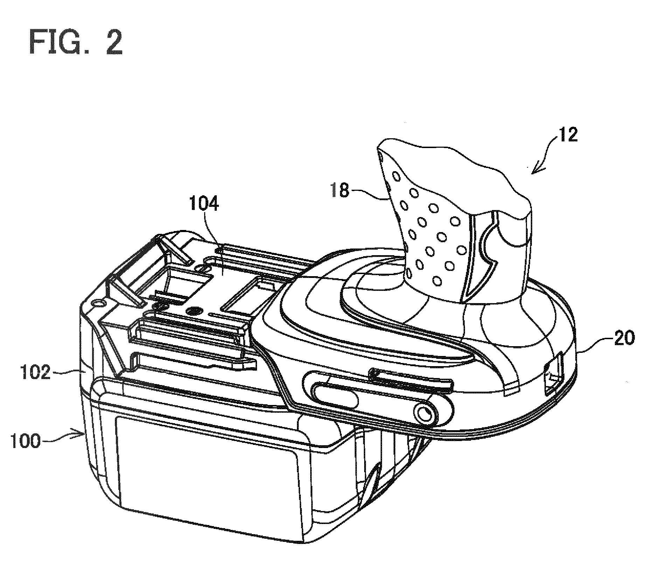

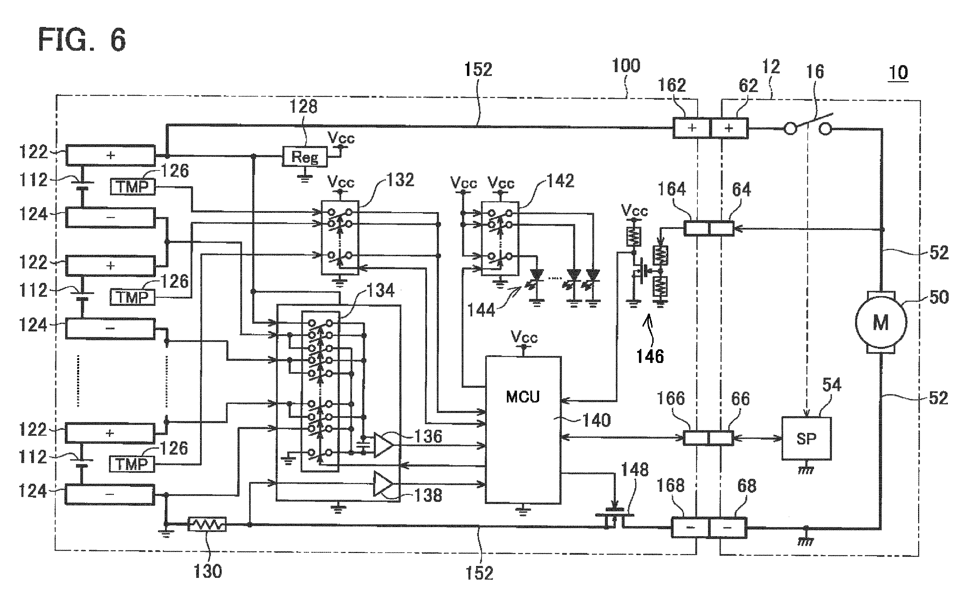

An electric power tool 10 according to a first embodiment will be described with reference to the drawings. FIGS. 1 and 2 show an appearance of the electric power tool 10. As shown in FIGS. 1 and 2, the electric power tool 10 includes a tool main body 12 and a battery pack 100 configured to be detachably attached to the tool main body 12. The battery pack 100 is a rechargeable battery pack and supplies electric power to the tool main body 12 as a power supply of the electric power tool 10. The tool main body 12 includes a tool holder 14 to which the tool can be detachably attached, a main switch 16 that is operated by a user, and a grip 18 that is grasped by the user. A motor 50 that drives the tool holder 14 and various circuits (see FIG. 6) are received in the tool main body 12.

The tool main body 12 includes a battery attachment portion 20. The battery attachment portion 20 is formed on the lower end of the grip 18. As shown in FIG. 2, a battery pack 100 is detachably attached to the battery attachment portion 20. The battery pack 100 includes a tool connecting portion 104 that is slidably engaged with the battery attachment portion 20. The tool connecting portion 104 is formed on the upper surface of a housing 102 of the battery pack 100. When the battery pack 100 is slid to the rear side in relation to the battery attachment portion 20, the battery pack 100 can be attached to the battery attachment portion 20. When the battery pack 100 is slid to the front side in relation to the battery attachment portion 20, the battery pack 100 can be detached from the battery attachment portion 20. When the battery attachment portion 20 is attached to the battery pack 100, the battery pack 100 is mechanically and electrically connected to the tool main body 12.

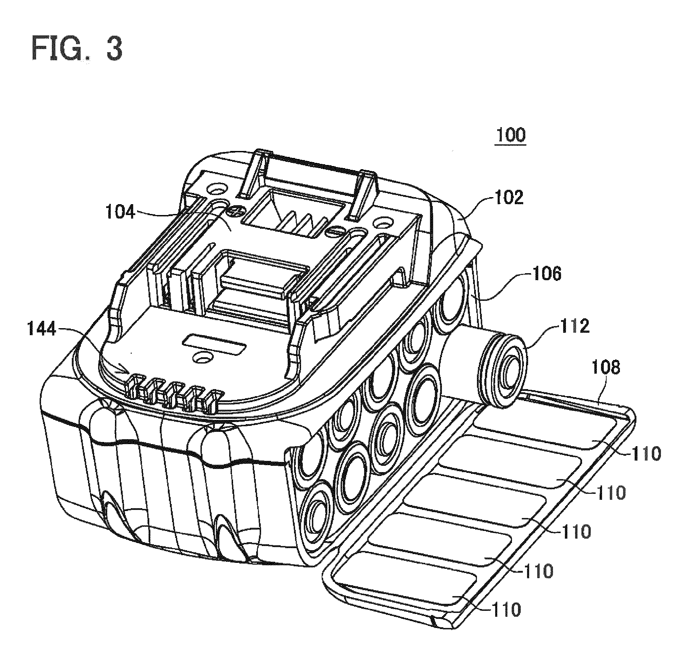

As shown in FIG. 3, the battery pack 100 includes a plurality of rechargeable battery cells 112. The plurality of rechargeable battery cells 112 is received in the housing 102. The rechargeable battery cells 112 are lithium-ion battery cells, and a nominal voltage thereof is 3.6 volts. In the battery pack 100 of the present embodiment, since ten lithium-ion battery cells 112 are connected in series, the total nominal voltage of the battery pack 100 is 36 volts. The type, number, and connection method (series/parallel) of the rechargeable battery cells 112 are not particularly limited but can be designed optionally. Moreover, the nominal voltage of the battery pack 100 is not limited to a specific voltage value.

In the battery pack 100 of the present embodiment, the housing 102 is configured to be opened and closed. That is, the housing 102 includes an opening 106 and a cover 108 that opens and closes the opening 106. The cover 108 can liquid-tightly block the opening 106. A plurality of electrode plates 110 is arranged on the inner surface of the cover 108. The respective electrode plates 110 make contact with the rechargeable battery cells 112 adjacent thereto to electrically connect these rechargeable battery cells. The opening 106 is sufficiently larger than the rechargeable battery cells 112 so that the rechargeable battery cells 112 can be inserted into and taken out of the housing 102 through the opening 106.

As described above, the battery pack 100 of the present embodiment is configured to removably receive the respective rechargeable battery cells 112 individually. Accordingly, one or more rechargeable battery cells 112 in the housing 102 can be replaced with one or more rechargeable battery cells newly prepared as necessary. As is well known, the rechargeable battery cells 112 deteriorate when they are repeatedly charged and discharged. Thus, the performance of the battery pack 100 deteriorates when the battery pack 100 is used repeatedly. In many cases, in the battery pack 100 degraded in performance, not all of the rechargeable battery cells 112 are deteriorated, but only part of the rechargeable battery cells 112 is greatly deteriorated or broken. Thus, it is possible to sufficiently recover the performance of the battery pack 100 by replacing only the deteriorated or broken rechargeable battery cell 112. By enabling the rechargeable battery cells 112 to be replaced individually, usable rechargeable battery cells 112 can be prevented from being wastefully discarded and therefore the respective rechargeable battery cells 112 can be used to their service life.

The battery pack 100 includes an indicator 144. The indicator 144 is controlled by a main controller 140 (see FIG. 6) described later. The indicator 144 provides such an indication that the user can specify one or a plurality of deteriorated or broken rechargeable battery cells 112 when the one or plurality of rechargeable battery cells 112 is deteriorated or broken. In the present embodiment, for example, the indicator 144 includes a plurality of light-emitting diodes which is configured to emit light when a rechargeable battery cell 112 corresponding to the light-emitting diode that emits light is deteriorated or broken. The indicator 144 may be one which uses a 7-segment display, a dot matrix display, or a liquid crystal display. With the indication of the indicator 144, the user can replace the deteriorated or broken rechargeable battery cell 112 without a mistake. The process of the main controller 140 specifying the deteriorated or broken rechargeable battery cell 112 will be described later.

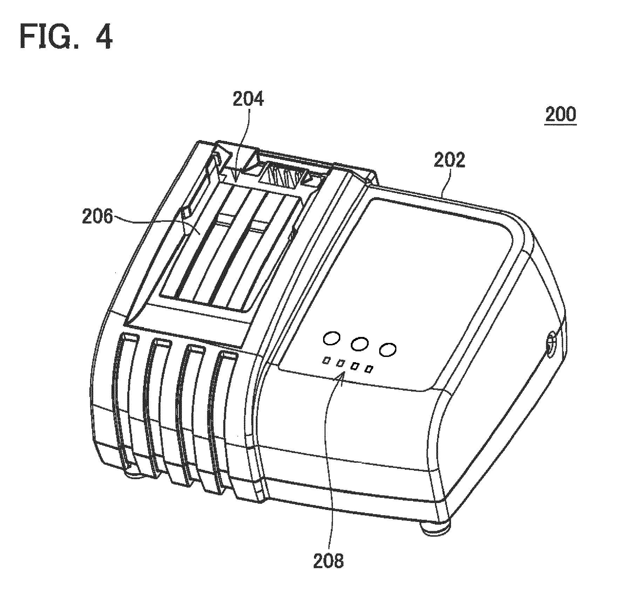

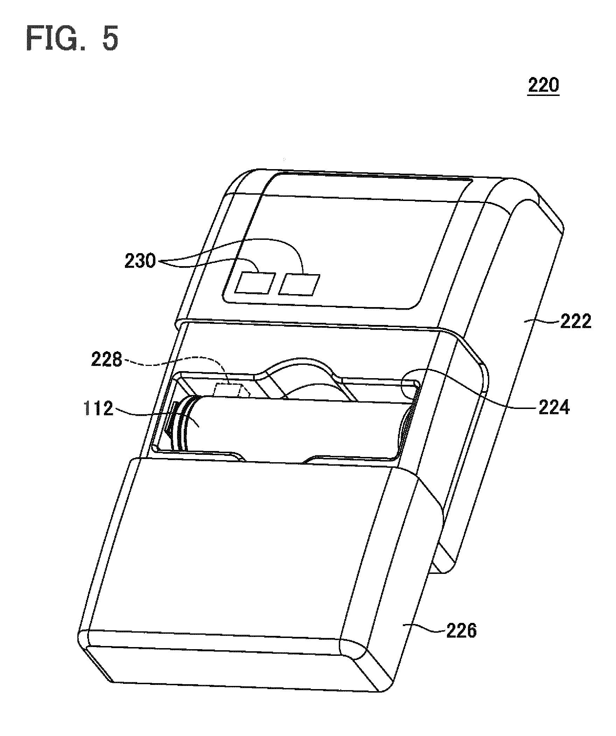

The electric power tool 10 of the present embodiment includes a pack charger 200 shown in FIG. 4 and a cell charger 220 shown in FIG. 5. The pack charger 200 is a charger that charges the battery pack 100 by connecting to an AC power supply (outlet). The pack charger 200 includes a pack attachment portion 204 to which the battery pack 100 is detachably attached. The pack attachment portion 204 is formed on an upper surface of a housing 202 of the pack charger 200. The pack attachment portion 204 includes a plurality of terminals for electrically connecting to the battery pack 100. The plurality of terminals is covered by a protection plate 206 and is not illustrated in FIG. 4. Moreover, the pack charger 200 includes an indicator 208. The indicator 208 displays information such as charging, completion of charging, and various abnormalities. The indicator 208 of the present embodiment is configured using a plurality of light-emitting diodes, and the configuration thereof is not particularly limited similarly to the indicator 144 of the battery pack 100.

The pack charger 200 is communicably connected with the main controller 140 of the battery pack 100 when the battery pack 100 is attached thereto. Moreover, the pack charger 200 can allow the indicator 144 to indicate a deteriorated or broken rechargeable battery cell 112 according to an instruction from the main controller 140. Due to this, even when the user charges the battery pack 100, the user can be informed of the presence of the deteriorated or broken rechargeable battery cell 112 and be prompted to replace the same.

On the other hand, the cell charger 220 is a charger that charges individual rechargeable battery cells 112 by connecting to an AC power supply (outlet). The cell charger 220 includes a cell attachment portion 224 to which the rechargeable battery cell 112 can be detachably attached. The cell attachment portion 224 is formed on the front surface of a housing 222 of the cell charger 220. The cell attachment portion 224 includes a plurality of terminals for electrically connecting to the rechargeable battery cell 112. Moreover, the cell charger 220 includes a cover 226 that slides over the cell attachment portion 224 and an indicator 230. The indicator 230 displays information such as charging, completion of charging, and various abnormalities. The indicator 230 of the present embodiment is configured using a plurality of light-emitting diodes, and the configuration thereof is not particularly limited similarly to the indicator 144 of the battery pack 100.

Further, the cell charger 220 includes a temperature sensor 228. The temperature sensor 228 is disposed near the cell attachment portion 224 and can measure the temperature of the rechargeable battery cell 112. The cell charger 220 can control a charging current and a charging voltage of the rechargeable battery cell 112 according to the detection result of the temperature sensor 228. In general, the cell charger 220 charges the rechargeable battery cell 112 while monitoring the temperature and output voltage of the rechargeable battery cell 112 and finishes the charging when the output voltage of the rechargeable battery cell 112 reaches a predetermined upper limit value. In this case, the cell charger 220 performs charging while measuring the time elapsed from the start of the charging. When the output voltage of the rechargeable battery cell 112 reaches the predetermined upper limit value in a period shorter than a predetermined lower limit period, it is determined that the rechargeable battery cell 112 is deteriorated or broken and the indicator 230 displays the determination result. Alternatively, when the output voltage of the rechargeable battery cell 112 does not reach a predetermined upper limit value even after the elapse of a predetermined upper limit period, it is determined that the rechargeable battery cell 112 is deteriorated or broken, and the indicator 230 displays the determination result.

In general, the user charges the battery pack 100 using the pack charger 200 and does not need to use the cell charger 220. However, when the deteriorated or broken rechargeable battery cell 112 is replaced, the user can effectively use the cell charger 220. For example, when the user tries to charge the rechargeable battery cell 112 determined to be deteriorated or broken using the cell charger 220, the user can check whether the rechargeable battery cell 112 is actually deteriorated or broken. Moreover, when the user charges a new rechargeable battery cell 112 prepared as a replacement using the cell charger 220 in advance, the user can match the charge level with the existing rechargeable battery cells 112.

Next, the electrical structure of the tool main body 12 will be described with reference to FIG. 6. The tool main body 12 includes the motor 50 and a tool controller 54. The tool controller 54 is connected to the main switch 16. A speed command signal is transmitted from the main switch 16 to the tool controller 54 according to the amount of operation that the user applies to the main switch 16. Further, the tool main body 12 includes a positive input terminal 62, a first communication terminal 64, a second communication terminal 66, and a negative input terminal 68. These terminals are arranged in the battery attachment portion 20 of the tool main body 12.

The positive input terminal 62 and the negative input terminal 68 are connected to the motor 50 via a power supply circuit 52. The main switch 16 is provided in the power supply circuit 52 that connects the positive input terminal 62 and the motor 50. The first communication terminal 64 is connected to the power supply circuit 52 between the main switch 16 and the motor 50. Due to this, during the period when the main switch 16 is turned on, the potential of the first communication terminal 64 is the same as the potential of the positive input terminal 62. During the period when the main switch 16 is turned off, the potential of the first communication terminal 64 is the same as the potential of the negative input terminal 68. That is, the first communication terminal 64 outputs high and low voltage signals according to the turning on and off of the main switch 16. The second communication terminal 66 is electrically connected to the tool controller 54.

Subsequently, the electrical structure of the battery pack 100 will be described with reference to FIG. 6. As shown in FIG. 6, the battery pack 100 includes a positive output terminal 162, a first communication terminal 164, a second communication terminal 166, and a negative output terminal 168. These terminals are arranged in the tool connecting portion 104 of the battery pack 100. When the battery pack 100 is attached to the tool main body 12, the positive output terminal 162, the first communication terminal 164, the second communication terminal 166, and the negative output terminal 168 of the battery pack 100 are electrically connected to the positive input terminal 62, the first communication terminal 64, the second communication terminal 66, and the negative input terminal 68 of the tool main body 12, respectively. Due to this, the battery pack 100 is electrically connected to the tool main body 12.

The battery pack 100 includes a plurality of cell positive connection terminals 122 and a plurality of cell negative connection terminals 124. The plurality of cell positive connection terminals 122 and the plurality of cell negative connection terminals 124 are electrically connected to the plurality of rechargeable battery cells 112 received in the housing 102. The plurality of rechargeable battery cells 112 is connected in series by the plurality of cell positive connection terminals 122 and the plurality of cell negative connection terminals 124. The cell positive connection terminal 122 and the cell negative connection terminal 124 positioned at both ends of the plurality of series-connected rechargeable battery cells 112 are electrically connected to the positive output terminal 162 and the negative output terminal 168 through the power supply circuit 152. Due to this, the plurality of series-connected rechargeable battery cells 112 is electrically connected to the tool main body 12 by the positive output terminal 162 and the negative output terminal 168.

A shunt resistor 130 for measuring a current value and a switch circuit (in this example, a field-effect transistor) 148 for shutting off electric power supply to the tool main body 12 are provided in the power supply circuit 152 disposed between the cell negative connection terminal 124 and the negative output terminal 168. The shunt resistor 130 is connected to the main controller 140 via an amplifier circuit 138. The switch circuit 148 is connected to the main controller 140 and is controlled by the main controller 140. The main controller 140 can detect a discharge current of the rechargeable battery cell 112 based on a voltage occurring across the shunt resistor 130. The main controller 140 can shut off the electric power supply to the tool main body 12 by turning off the switch circuit 148 when the detected current value reaches a predetermined upper limit value.

The respective cell positive connection terminals 122 and the respective cell negative connection terminals 124 are connected to the main controller 140 via a multiplexer 134 and a buffer circuit 136. Due to this, the output voltages of the respective rechargeable battery cells 112 are input to the main controller 140. The main controller 140 monitors the output voltages of the respective rechargeable battery cells 112 and determines that the rechargeable battery cell 112 is deteriorated or broken when the output voltage of the rechargeable battery cell 112 is lower than a predetermined lower limit value or higher than a predetermined upper limit value. In this case, the main controller 140 allows the indicator 144 to provide such an indication that the user can specify the deteriorated or broken rechargeable battery cell 112. As shown in FIG. 6, the indicator 144 of the present embodiment includes a plurality of light-emitting diodes, and the plurality of light-emitting diodes is connected to the main controller 140 via the multiplexer 142. The main controller 140 allows the light-emitting diode corresponding to the deteriorated or broken rechargeable battery cell 112 to emit light to inform the user of the deteriorated or broken rechargeable battery cell 112. Further, the main controller 140 can shut off the electric power supply to the tool main body 12 by turning off the switch circuit 148.

The battery pack 100 includes a plurality of temperature sensors 126. The temperature sensors 126 of the present embodiment are thermistors, for example. The temperature sensor 126 is disposed near the corresponding rechargeable battery cell 112 and outputs a temperature signal corresponding to the temperature of the corresponding rechargeable battery cell 112. The plurality of temperature sensors 126 is connected to the main controller 140 via the multiplexer 132. The main controller 140 monitors the temperatures detected by the respective temperature sensors 126 and determines that a temperature abnormality has occurred in the rechargeable battery cell 112 when the detected temperature is higher than a predetermined upper limit value. In this case, the main controller 140 can allow the indicator 144 to indicate the rechargeable battery cell 112 having a temperature abnormality. Further, the main controller 140 can shut off the electric power supply to the tool main body 12 by turning off the switch circuit 148.

The battery pack 100 includes a main switch detection circuit 146. The main switch detection circuit 146 is connected to the first communication terminal 164 and can detect the turning on and off of the main switch 16. The main switch detection circuit 146 outputs a high-level voltage signal (Vcc) to the main controller 140 during the period when the main switch 16 is turned off and outputs a low-level voltage signal (GND) to the main controller 140 during the period when the main switch 16 is turned on. The main controller 140 can detect the turning on and off of the main switch 16 based on the output signal of the main switch detection circuit 146. When the switch circuit 148 is turned off due to the abnormality or the like, the main controller 140 maintains the switch circuit 148 to be turned off until the main switch 16 is turned off.

The main controller 140 is connected to the second communication terminal 166 and is communicably connected to the tool controller 54 of the tool main body 12. As described above, the tool controller 54 outputs a speed command signal according to the amount of operation that the user applies to the main switch 16. The main controller 140 receives the speed command signal and can perform PWM control on the switch circuit 148 according to the received speed command signal. Due to this, it is possible to adjust the rotation speed of the motor 50 according to the amount of operation that the user applies to the main switch 16.

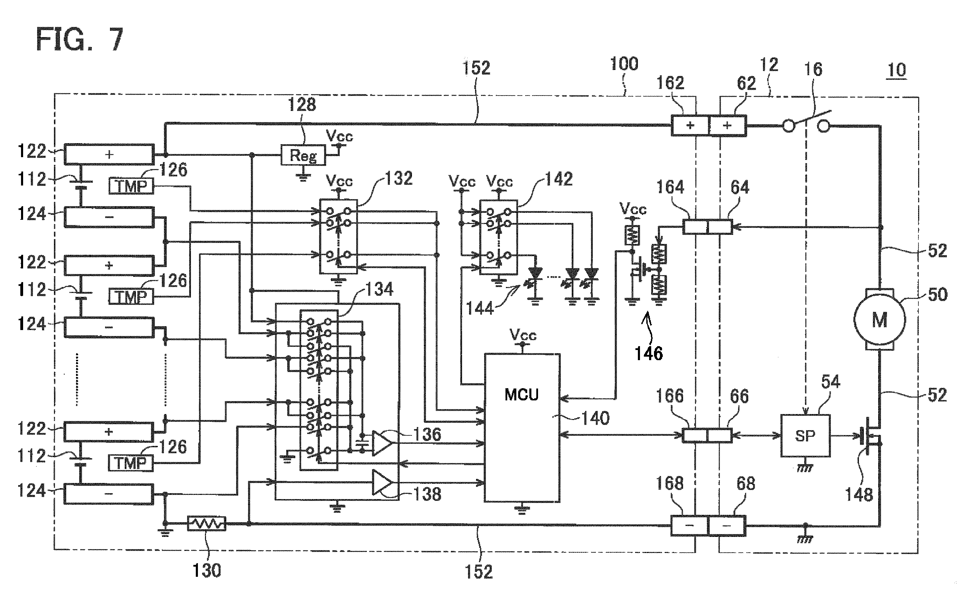

FIG. 7 shows a modification of the circuit configuration of the tool main body 12 and the battery pack 100. As shown in FIG. 7, the switch circuit 148 may be provided in the tool main body 12. In this case, the tool controller 54 may be connected to the switch circuit 148, and the switch circuit 148 may be controlled by the tool controller 54. The tool controller 54 is connected to the main controller 140 by the second communication terminals 66 and 166. The main controller 140 can turn off the switch circuit 148 with the aid of the tool controller 54 when the abnormality or the like is detected. That is, the main controller 140 may issue a command to the tool controller 54, and the tool controller 54 having received the command may turn off the switch circuit 148.

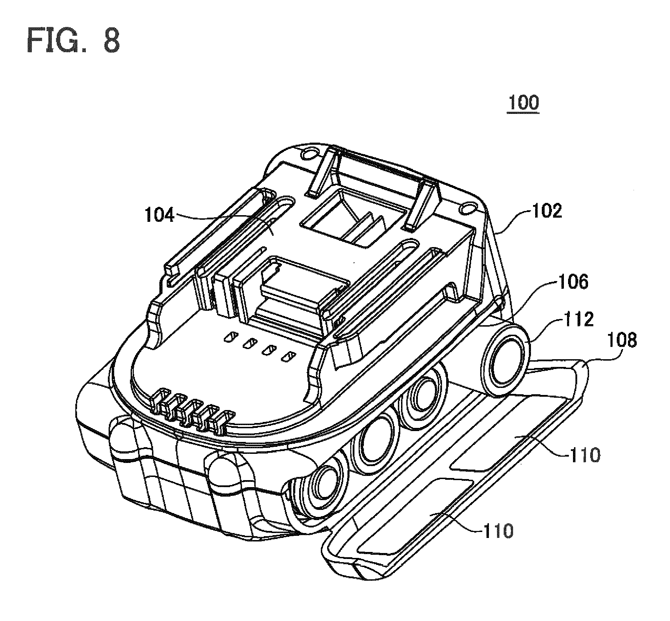

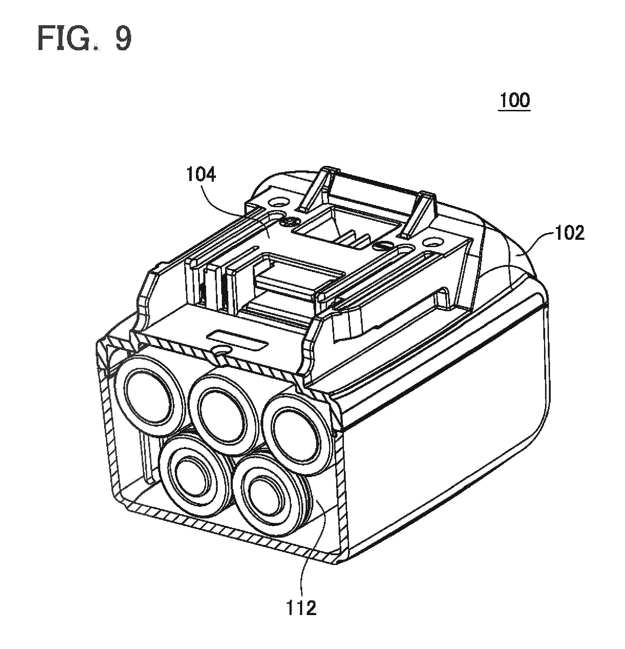

As described above, although the battery pack 100 of the present embodiment includes ten lithium-ion rechargeable battery cells 112, the type and number of the rechargeable battery cells 112 are not particularly limited. As shown in FIGS. 8 and 9, the number and arrangement of the rechargeable battery cells 112 can be appropriately changed as long as the respective rechargeable battery cells 112 can be removably received individually.

### SECOND EMBODIMENT

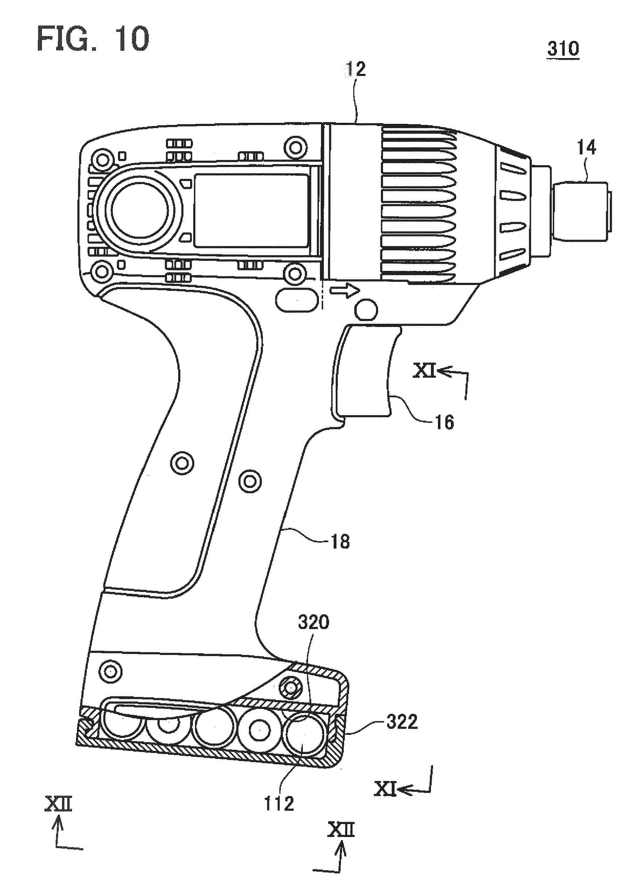

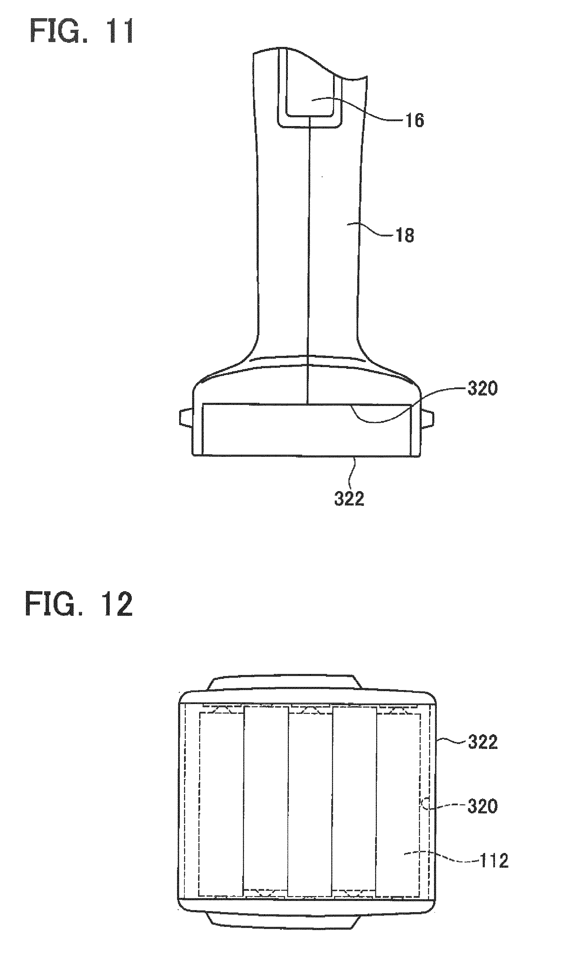

An electric power tool 310 according to a second embodiment will be described with reference to the drawings. In the electric power tool 10 of the first embodiment, the plurality of rechargeable battery cells 112 is received in the battery pack 100 that is detachably attached to the tool main body 12. However, in the electric power tool 310 of the present embodiment, as shown in FIGS. 10, 11, and 12, the plurality of rechargeable battery cells 112 is directly attached to the tool main body 12. Hereinafter, the electric power tool 310 of the present embodiment will be described, and the same constituent components as the electric power tool 10 of the first embodiment will be denoted by the same reference numerals and will not be described.

The tool main body 12 of the electric power tool 310 includes a cell receiving portion 320. The cell receiving portion 320 can receive a plurality of rechargeable battery cells 112. The cell receiving portion 320 is formed on the distal end of the grip 18. The cell receiving portion 320 includes a cover 322 that can be opened and closed. When the cover 322 is opened, the respective rechargeable battery cells 112 can be removably received in the cell receiving portion 320 individually. When the cover 322 is closed, the cell receiving portion 320 is liquid-tightly blocked.

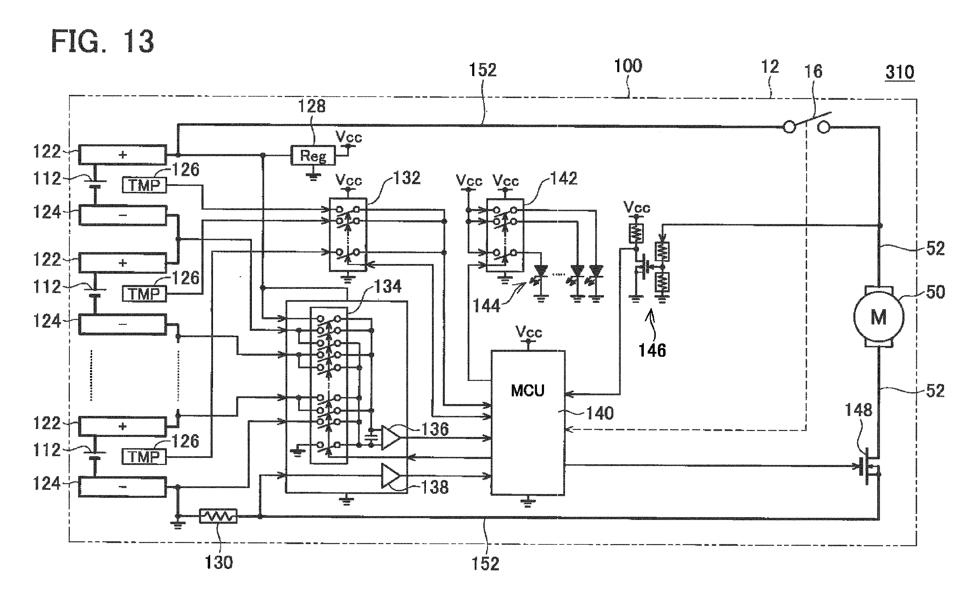

FIG. 13 shows a circuit configuration of the electric power tool 310 of the present embodiment. As can be understood by comparing the circuit configuration shown in FIG. 13 with the circuit configurations shown in FIGS. 6 and 7, the circuit configuration of the electric power tool 310 of the present embodiment corresponds to one in which the circuit configurations of the tool main body 12 and the battery pack 100 of the first embodiment are integrated. Thus, regarding the circuit configuration of the present embodiment, the description of the first embodiment will be referenced, and redundant description will not be provided. As a difference from the first embodiment, in the present embodiment, the tool controller 54 described in the first embodiment is integrated into the main controller 140. Moreover, the plurality of cell positive connection terminals 122 and the plurality of cell negative connection terminals 124 are arranged in the cell receiving portion 320. Further, the plurality of temperature sensors 126 is disposed near the cell receiving portion 320 so that the temperatures of the plurality of rechargeable battery cells 112 can be detected. Moreover, the indicator 144 is arranged at a position that the user of the tool main body 12 can observe the indicator 144.

The electric power tool 310 of the present embodiment is also configured to removably receive the respective rechargeable battery cells 112 individually. Due to this, one or a plurality of rechargeable battery cells 112 in the tool main body 12 can be replaced with one or a plurality of rechargeable battery cells prepared separately as necessary. By enabling the rechargeable battery cells 112 to be replaced individually, usable rechargeable battery cells 112 can be prevented from being wastefully discarded and therefore the respective rechargeable battery cells 112 can be used to their service life.

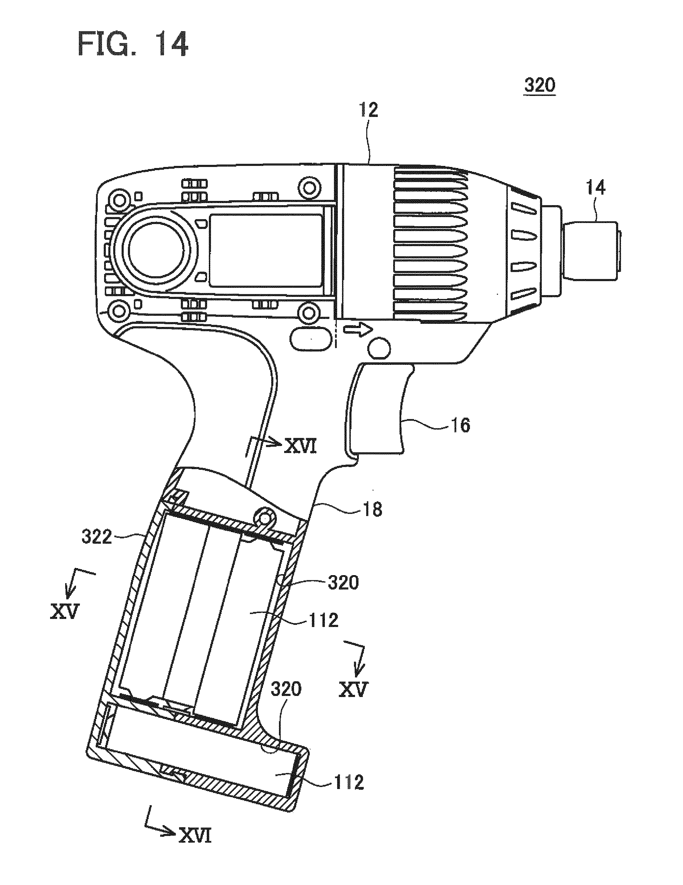

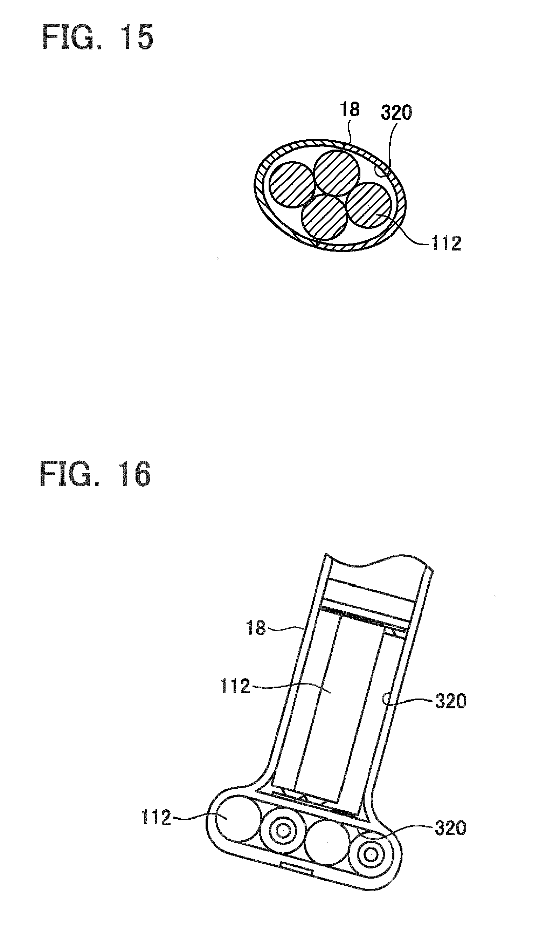

As an example, the tool main body 12 of the present embodiment includes five lithium-ion rechargeable battery cells 112. However, the type and number of the rechargeable battery cells 112 are not particularly limited. As shown in FIGS. 14, 15, and 16, the number and arrangement of the rechargeable battery cells 112 can be appropriately changed as long as the respective rechargeable battery cells 112 can be removably received individually. In the modifications shown in FIGS. 14, 15, and 16, eight lithium-ion rechargeable battery cells 112 can be received in the cell receiving portion 320 of the tool main body 12, and the respective rechargeable battery cells 112 can be removably received by detaching the cover 322.

Specific embodiments of the present teachings are described above, but they merely illustrate some possibilities of the teachings and do not restrict the claims thereof. The art set forth in the claims includes variations and modifications of the specific examples set forth above.

The technical elements disclosed in the specification or the drawings may be utilized separately or in all types of combinations, and are not limited to the combinations set forth in the claims at the time of filing of the application. Furthermore, the art disclosed herein may be utilized to simultaneously achieve a plurality of aims or to achieve one of these aims.

## Claims

1. An electric power tool powered by a plurality of rechargeable battery cells and configured to removably receive respective rechargeable battery cells individually.

2. The electric power tool as in claim 1, comprising:
a monitor circuit configured to monitor states of respective battery cells; and
an indicator circuit configured to indicate the states of the respective battery cells monitored by the monitor circuit.

3. The electric power tool as in claim 2, wherein
the monitor circuit is configured to monitor output voltages, temperatures, or a combination thereof of the respective battery cells, and
the indication circuit is configured to indicate whether the output voltages or the temperatures of the respective battery cells are within a predetermined range.

4. The electric power tool as in claim 3, further comprising a switch circuit configured to shut off electric power supply from the plurality of rechargeable battery cells,
wherein the monitor circuit is configured to make the switch circuit open when the output voltage or the temperature of at least one rechargeable battery cell is beyond the predetermined range.

5. The electric power tool as in any one of claims 1 to 4, comprising:
a tool main body; and
a battery pack configured to house the plurality of rechargeable battery cells and be detachably attached to the tool main body.

6. The electric power tool as in claim 5, further comprising a pack charger that charges the battery pack, wherein
the battery pack comprises a monitor circuit configured to monitor states of respective battery cells, and
the pack charger is configured to be connected with the monitor circuit in a communicable fashion and comprises an indicator circuit configured to indicate states of the respective battery cells monitored by the monitor circuit.

7. The electric power tool as in any one of claims 1 to 6, further comprising a cell charger that charges the rechargeable battery cell detached from the electric power tool, wherein the cell charger comprises a temperature sensor that detects a temperature of the rechargeable battery cell.

8. The electric power tool as in claim 7, wherein the cell charger is configured to finish charging of the rechargeable battery cell when the output voltage of the rechargeable battery cell under the charging reaches a predetermined upper limit or when a predetermined period of time passes from a start of the charging.

9. A battery pack to power an electric power tool, the battery pack comprising a plurality of rechargeable battery cells and configured to removably receive respective rechargeable battery cells individually.
